# EUROPEAN PATENT APPLICATION

(11) **EP 0 937 991 A2**
(43) Date of publication of application: **25.08.1999**
(21) Application number: 99300892.9
(22) Date of filing: 08.02.1999
(51) Int. Cl.: G01R 31/311, G01R 31/317, G01R 31/316

(54) **System and method for determining the delay makeup of a circuit**

(30) Priority: 19.02.1998 US 26301
(71) Applicant: International Business Machines Corporation, Armonk, NY 10504 (US)
(72) Inventor: Anderson, Carl John, Austin, Texas 78731 (US); Huisman, Leendert Marinus, South Burlington, Vermont 05403 (US); Knebel, Daniel Ray, Carmel, New York 10512 (US); Nigh, Phillip J., Williston, Vermont 05495 (US); Sanda, Pia Naoko, Chappaqua, New York 10514 (US)
(74) Representative: Williams, Julian David

(57) **Abstract**

A system and method for determining the delay makeup of an integrated circuit are described. As a first step in the method, a path of interest is determined by manual or automated techniques, and a test input for exercising each device in the path is derived. The test input is applied to the path under test, and the circuit is monitored for all switching activity occurring responsive to the input. The location of each switching event is recorded and compared with mask shape data and net list data of the circuit to determine the identity of each transistor for which switching activity was detected. The time of occurrence data associated with each switching event can then be used to compute the delay attributable to each element in the path. In a preferred embodiment of the invention, the location and time data are gathered using an optical measurement system that can detect the emission of light from device switching events on the chip.

## Description

The present invention relates to a system and method for determining the delay characteristics of paths within integrated circuits.

There is no robust technique for determining the delay makeup of signal paths within an integrated circuit. Such a technique would be useful for solving a number of problems related to integrated circuit development and production including performance optimization, yield enhancement, initial design bring up, and hardware defect analysis.

Performance optimization requires identification of cycle-speed limiting paths and making adjustments to the circuitry, if possible, to increase the speed of those paths. Detailed knowledge of the delay apportionment among various structures within the integrated circuit is required to make such adjustments.

Initial bring up of an integrated circuit sometimes fails due to unanticipated design flaws or unpredictable circuit behaviors which cause timing problems. Quick resolution of these problems relies on finding the source of the problem and understanding what circuitry is affected.

Hardware defects sometimes occur which do not cause a static or "DC" failure but do change localized circuit performance resulting in timing problems or less than expected operating speed. Such defects are difficult to diagnose because they may be buried deep inside the IC. Locating such defects is important to understanding and improving IC yields and reliability.

Detailed delay characterization of circuit paths in integrated circuits is currently accomplished primarily by software modeling. Such modeling techniques are not conclusive and are subject to modeling errors or unknown hardware characteristics or defects. Hardware measurements using standard electrical testers are limited in that only observable points (e.g. a latch) can be monitored. It is not possible to understand the delays of each component in a path from such measurements.

In accordance with the present invention, there is now provided a method for analyzing the delay makeup of signal paths within an integrated circuit, comprising: providing a circuit to be tested; identifying a path of interest in the circuit; applying a test input signal to be processed by the path of 'interest; monitoring and recording the location and time of each switching event by each device in the path of interest.

Viewing the present invention from another aspect, there is now provided a method for analyzing the delay makeup of signal paths within an integrated circuit, comprising: providing a circuit to be tested; identifying a path of interest in the circuit; determining a test signal to be applied to the path; applying the test signal to the identified path; monitoring switching activity of devices in the path during application of the test signal; outputting data representing when selected circuits in the path switched; comparing the output data to expected data to identify unacceptable delay characteristics.

Viewing the present invention from yet another aspect, there is now provided a system for analyzing the delay makeup of signal paths within an integrated circuit, comprising: means for identifying a path of interest in the circuit; means for applying a test input signal to be processed by the path of interest; means for monitoring and recording the location and time of each switching event by each device in the path of interest.

Viewing the present invention from a further aspect, there is now provided a system for analyzing the delay makeup of signal paths within an integrated circuit, comprising: means for identifying a path of interest in the circuit; means for determining a test signal to be applied to the path; means for applying the test signal to the identified path; means for monitoring switching activity of devices in the path during application of the test signal; means for outputting data representing when selected circuits in the path switched; means for comparing the output data to expected data to identify unacceptable delay characteristics.

In a preferred embodiment of the present invention, there is provided a method is described for analyzing the delay makeup of signal paths within an IC, comprising: providing an IC sample, determining paths of interest, generating path tests to propagate signals along a given path (either manually, or using an automated tool such as IBM Testbench), determining the physical locations of circuits in the path to be observed, monitoring switching activity during repeated application of path tests with a measurement technique such as, but not limited to, photon emission imaging, output a data representation of when selected circuits switch, compare it to expected data (which can be a reference).

Preferred embodiments of the present invention will now be described, by way of example only, with reference to the accompanying drawings, in which:
FIG. 1 is a functional block diagram of a system in accordance with the invention; and
FIG. 2 is a flow diagram of a preferred implementation of a method in accordance with the invention.

A preferred embodiment of the present invention provides a new method of taking hardware measurements and using those measurements to determine individual component delays. Interesting components are identified with the assistance of a software model, standard electrical tests, or other methods. These components are then located and observed using a measurement technique such as photon emission imaging or electron beam potential analysis. The observations are then converted to circuit delays which can be compared to expected results.

The paths of interest may be determined in a number of ways. One such method is described in commonly owned and copending US Patent Application No. 08/026,286 (IBM Docket No. YO998-071), entitled "Method for Identifying Long Paths in Integrated Circuits", filed concurrently herewith and incorporated herein by reference. Another example would be from the sorted output of a path timing tool which would predict the slowest or fastest paths in the IC.

Given the path(s) of interest, an automated path test generator may provide a set of test vectors which stimulate the path. Alternatively, existing test vectors known to exercise the selected path may be used, or such tests may be created manually. Layout to netlist correspondence is used to determine locations of the circuits that will be stimulated by the paths. The patterns and location information is input to a tool and measurements are taken. The collected information is output in a form suitable for comparison to switching activity.

The output data may then be compared to reference data, which may be obtained from hardware measurements or software simulation. It may also be used as input to a design tool or model to characterize the delay makeup of the measured path.

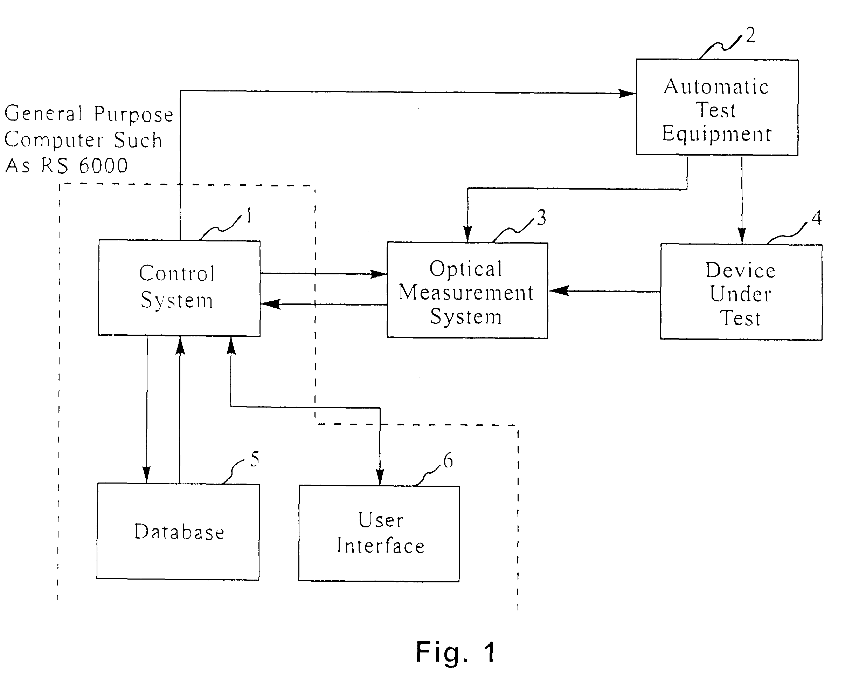

FIG. 1 presents a block diagram of a preferred embodiment of the invention. The embodiment includes a control system 1, which executes the processes to be described. Control system 1 is coupled to and obtains information from a database 5, such information describing the physical and logical design of the device under test in the form of net list data and mask shape data, results of hardware tests previously performed on the device under test, software computations of expected performance of the device under test, and previously stored intermediate results, such as location and temporal data describing activity on the chip occurring under test conditions. Similarly, control system 1 writes results of optical measurements, software computations, and intermediate results back to the database 5.

The control system 1 interacts with an operator through a user interface 6. The user interface provides output to the user in the form of graphs (e.g., by means of Stanford University's Sigview tool) and lists, allows the user to select a preferred visualization mode, select windows, nets or transistors for analysis, as well as provide input to the system to control such non-automated system parameters as image magnification capability of the optical measuring system 3, movement of the stage supporting the device under test, and registration of the field of view of the imaging tool with layout shape data. The control system 1 further operates to provide operator commands, database information, and control information to the automatic test equipment ATE 2 and the optical measurement system OMS 3. In a preferred embodiment, the control system 1, database 5 and user interface 6 are embodied as software running on a general purpose computer, such as an IBM RISC System 6000.

ATE 2, which in a preferred embodiment is a Hewlett Packard model HP82000 or HP83000 testing apparatus, stimulates the device under test DUT 4 by applying predetermined logical inputs to the circuit for testing for the presence of desired results. ATE 2 also provides synchronization signals to the optical measurement system 3 to coordinate the generation of images of the DUT 4 as the input logical signal is processed. Each device in the DUT 4 that switches in response to the input signal will produce photon emissions that can be detected by the OMS 3. The OMS 3 records the x,y location of each emission, along with the time of each recorded emission throughout the period of stimulation, to thereby generate a record of the sequence and location of all measured circuit switching activity on the chip that resulted at the DUT 4 due to the input signal.

OMS 3 will provide the location and time data to control system 1, which will store the data as a file in database 5. The recorded location data of switching events can be compared with mask shape data stored in the data base to determine the name of the transistor corresponding to the switching event, and the name of the transistor can be compared to the netlist to determine the circuit path that includes the switching transistor. When all recorded data has thus been processed, a chronologically ordered record of all switching activity on the chip can be constructed. This record can be compared either manually or automatically using a computer program to determine the cause of path failure.

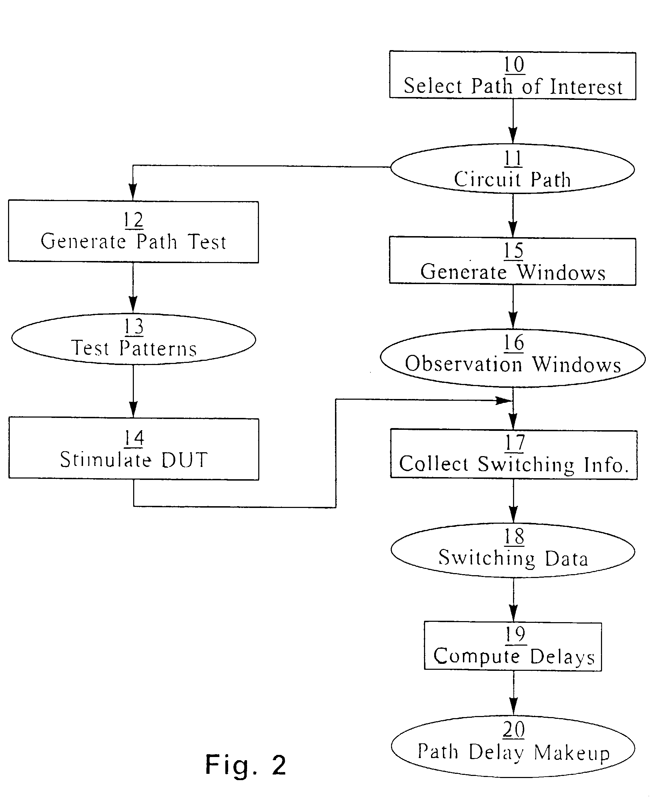

FIG. 2 presents a flowchart of a preferred implementation of a method in accordance with the invention. In the flow chart, boxes depict processes and ovals depict process outputs.

First, a path of interest in the circuit is selected 10. The path is selected, for instance, because it is suspected of having caused a failure, or simply because it is desired to optimize the particular path. The path information, which comprises a net list describing a list of circuit device elements and their interconnectivity, is written to a file 11.

The path information is then used by two processes, which may be executed in parallel.

In one process path, a set of path tests is generated 12 so that each of the circuits described in the input path information may be stimulated. The set of test patterns can be generated using one of several different techniques, according to the user's preference. A first technique is to generate the test path automatically using a tool such as IBM Testbench, which can determine a path in response to providing pairs of data such as: primary input and primary output; primary input and latch; latch and primary output; and latch and latch. The specification of these pairs of path elements uniquely identifies one or more paths and allows the Testbench tool to compute a test input that will exercise all devices in the path.

A second technique, which can be used when the characteristics of the circuit are known in advance by the designer, is simply to manually specify a pattern for which it is known that all devices in a path will be exercised.

A third technique might be to select a path that was identified by a path extraction tool such as Epic's Path mill as being the slowest or fastest, e.g., path on the chip, and to provide the specification of such path to a tool such as Testbench, as described above.

After the set of test patterns has been selected, the set is output to a file 13 and transferred to automatic test equipment for eventual stimulation of the DUT.

In a second process path, one or more windows are generated 15 and output as a set of coordinate pairs 16 which describe the lower left and upper right hand corners of rectangles such that overlaying the rectangles on the device under test will enclose the observable portions of every device described in the input path information. A second technique corresponding to this process path provides the coordinates of a subset of regions enclosing the devices in the path which are of particular interest. A third technique provides the regions of interest manually or semiautomatically.

Next, the automatic test equipment stimulates the device under test 14 by applying the previously determined test patterns to the input of the DUT. The optical measuring apparatus collects device switching information 17 in the form of x,y location and time data for each light emission in the regions defined by the observation windows generated above. The collected switching data is output to a file 18.

A final process uses the switching data as input to compute delays 19 for each of the circuit components described by the path information. This information is output to a file 20 that describes the delay makeup of the path. The delay makeup information will take the form of a list of all devices in the path, along with the time at which each device in the path switched. Thus, the delay attributable to any device in the path can be computed simply by subtracting the recorded time data corresponding to that device from the recorded time data for the next downstream circuit element. A second technique for this final process would be to generate the delays manually.

In summary a system and method for determining the delay makeup of an integrated circuit have been hereinbefore described. As a first step in the method, a path of interest is determined by manual or automated techniques, and a test input for exercising each device in the path is derived. The test input is applied to the path under test, and the circuit is monitored for all switching activity occurring responsive to the input. The location of each switching event is recorded and compared with mask shape data and net list data of the circuit to determine the identity of each transistor for which switching activity was detected. The time of occurrence data associated with each switching event can then be used to compute the delay attributable to each element in the path. In a preferred embodiment of the invention, the location and time data are gathered using an optical measurement system that can detect the emission of light from device switching events on the chip.

While the invention has been described in particular with respect to preferred embodiments thereof, it will be understood that modifications to the disclosed embodiments can be effected without departing from the scope of the invention.

## Claims

1. A method for analyzing the delay makeup of signal paths within an integrated circuit, comprising:
providing a circuit to be tested;
identifying a path of interest in the circuit;
applying a test input signal to be processed by the path of interest;
monitoring and recording the location and time of each switching event by each device in the path of interest.

2. A method as claimed in claim 1, further comprising computing from the time of each switching event the delay attributable to the entire path.

3. A method as claimed in claim 1, further comprising computing the delay attributable to a particular device in the path from the difference between the switching time of the particular device and the switching time of a downstream device.

4. A method as claimed in claim 1, wherein the step of monitoring the location and time of each switching event is performed using an optical measurement system capable of detecting light emission from switching devices.

5. A method for analyzing the delay makeup of signal paths within an integrated circuit, comprising:
providing a circuit to be tested;
identifying a path of interest in the circuit;
determining a test signal to be applied to the path;
applying the test signal to the identified path;
monitoring switching activity of devices in the path during application of the test signal;
outputting data representing when selected circuits in the path switched;
comparing the output data to expected data to identify unacceptable delay characteristics.

6. A method as claimed in claim 5, wherein the step of monitoring is performed using photon emission imaging.

7. A system for analyzing the delay makeup of signal paths within an integrated circuit, comprising:
means for identifying a path of interest in the circuit;
means for applying a test input signal to be processed by the path of interest;
means for monitoring and recording the location and time of each switching event by each device in the path of interest.

8. A system as claimed in claim 7, comprising means for computing from the time of each switching event the delay attributable to the entire path.

9. A system as claimed in claim 7, comprising means for computing the delay attributable to a particular device in the path from the difference between the switching time of the particular device and the switching time of a downstream device.

10. A system as claimed in claim 1, wherein the means for monitoring the location and time of each switching event is includes an optical measurement system capable of detecting light emission from switching devices.

11. A system for analyzing the delay makeup of signal paths within an integrated circuit, comprising:
means for identifying a path of interest in the circuit;
means for determining a test signal to be applied to the path;
means for applying the test signal to the identified path;
means for monitoring switching activity of devices in the path during application of the test signal;
means for outputting data representing when selected circuits in the path switched;
means for comparing the output data to expected data to identify unacceptable delay characteristics.

12. A system as claimed in claim 11, wherein the means for monitoring is a photon emission imaging apparatus.
